# EUROPEAN PATENT APPLICATION

(11) **EP 4 109 497 A1**
(43) Date of publication of application: **28.12.2022**
(21) Application number: 22171266.4
(22) Date of filing: 03.05.2022
(51) Int. Cl.: H01L 21/48, H01L 23/15, H01L 23/498

(54) **ANGLED INTERCONNECT USING GLASS CORE TECHNOLOGY**

(30) Priority: 24.06.2021 US 202117357896
(71) Applicant: INTEL Corporation, Santa Clara, CA 95054 (US)
(72) Inventor: Dogiamis, Georgios C., Chandler, 85226 (US); Aleksov, Aleksandar, Chandler, 85286 (US); Strong, Veronica, Hillsboro, 97123 (US); Prabhu Gaunkar, Neelam, Chandler, 85225 (US); Kamgaing, Telesphor, Chandler, 85249 (US)
(74) Representative: Goddar, Heinz J.

(57) **Abstract**

Embodiments disclosed herein include package substrates with angled vias and/or via planes. In an embodiment, a package substrate comprises a core with a first surface and a second surface opposite from the first surface. In an embodiment, a first pad is on the first surface, and a second pad on the second surface, where the second pad is outside a footprint of the first pad. In an embodiment, the package substrate further comprises a via through a thickness of the core, where the via connects the first pad to the second pad.

## Description

### TECHNICAL FIELD

Embodiments of the present disclosure relate to electronic packages, and more particularly to package substrates with a glass core and angled interconnects and planes within the glass core.

### BACKGROUND

In existing package substrates pitch translation between a first surface (e.g., that is coupled to a die) and a second surface (e.g., that is coupled to a board) is typically done using fan-out routing. In fan-out routing, the vertical connections are made by vias that are orthogonal to the first surface, and lateral traces are made to provide the pitch translation. Such routing schemes, therefore, do not provide the shortest possible path between pads on the first surface and pads on the second surface. The longer traces result in a more lossy interconnect. Additionally, fan-out routing may require additional manufacturing complexity, especially for tight pitches where additional redistribution layers may be needed. Moreover, fan-out routing requires additional manufacturing of the lateral traces on either or both surfaces of the package substrate.

### BRIEF DESCRIPTION OF THE DRAWINGS

Figure 1A is a cross-sectional illustration of a glass core with top and bottom surfaces that are being exposed with a laser, in accordance with an embodiment.
Figure 1B is a cross-sectional illustration of the glass core with regions that have their morphology altered by the laser, in accordance with an embodiment.
Figure 1C is a cross-sectional illustration of the glass core with a via hole through a thickness of the glass core, in accordance with an embodiment.
Figure 1D is a cross-sectional illustration of the glass core with a via through the thickness of the glass core, in accordance with an embodiment.
Figure 2A is a plan view illustration of the glass core with a plurality of circular vias, in accordance with an embodiment.
Figure 2B is a plan view illustration of the glass core with a vertical via plane, in accordance with an embodiment.
Figure 3A is a perspective view illustration a via in a core that is oriented at a non-orthogonal angle with respect to a top surface of the core, in accordance with an embodiment.
Figure 3B is a perspective view illustration of a via plane in a core that is oriented at a non-orthogonal angle with respect to a top surface of the core, in accordance with an embodiment.
Figure 4A is a plan view illustration of a core with first pads with a first pitch and second pads with a second pitch that are connected by angled vias, in accordance with an embodiment.
Figure 4B is a cross-sectional illustration of the core in Figure 4A along line 4-4', in accordance with an embodiment.
Figure 4C is a cross-sectional illustration of the core in Figure 4A along line 4-4' with vias that have a first portion that is sloped and a second portion that is vertical, in accordance with an embodiment.
Figure 4D is a cross-sectional illustration of the core in Figure 4A along line 4-4' with vias that have a first portion that is sloped at a first angle and a second portion that is sloped at a second angle, in accordance with an embodiment.
Figure 5A is a perspective view illustration of a core with a via plane that is contacted by a plurality of angled vias, in accordance with an embodiment.
Figure 5B is a perspective view illustration of a core with a large via that is contacted by a plurality of angled vias, in accordance with an embodiment.
Figure 5C is a perspective view illustration of a core with a first via plane that is contacted by a second via plane that is angled, in accordance with an embodiment.
Figure 6 is a cross-sectional illustration of a die that is being contacted by a test socket that comprises angled pins, in accordance with an embodiment.
Figure 7A is a cross-sectional illustration of an electronic package with a core with angled vias, in accordance with an embodiment.
Figure 7B is a cross-sectional illustration of an electronic package with a pair of dies over a core with angled vias, in accordance with an embodiment.
Figure 7C is a cross-sectional illustration of an electronic package with a base die that couples together die tiles, where the base die is over a core with angled vias, in accordance with an embodiment.
Figure 8 is a cross-sectional illustration of an electronic system with a core that comprises angled vias, in accordance with an embodiment.
Figure 9 is a schematic of a computing device built in accordance with an embodiment.

### EMBODIMENTS OF THE PRESENT DISCLOSURE

Described herein are package substrates with a glass core and angled interconnects and planes within the glass core, in accordance with various embodiments. In the following description, various aspects of the illustrative implementations will be described using terms commonly employed by those skilled in the art to convey the substance of their work to others skilled in the art. However, it will be apparent to those skilled in the art that the present invention may be practiced with only some of the described aspects. For purposes of explanation, specific numbers, materials and configurations are set forth in order to provide a thorough understanding of the illustrative implementations. However, it will be apparent to one skilled in the art that the present invention may be practiced without the specific details. In other instances, well-known features are omitted or simplified in order not to obscure the illustrative implementations.

Various operations will be described as multiple discrete operations, in turn, in a manner that is most helpful in understanding the present invention, however, the order of description should not be construed to imply that these operations are necessarily order dependent. In particular, these operations need not be performed in the order of presentation.

As noted above, pitch translation in existing packaging architectures relies on vertical vias and horizontal traces that are formed in redistribution layers. Such routing schemes are longer than a point-to-point path between pads. This results in more lossy interconnects. Additionally, the routing may require multiple redistribution layers, which increases cost and complexity of the electronic package.

Accordingly, embodiments disclosed herein include angled vias that pass through a thickness of a core of the package substrate. The use of angled vias allows for a direct path between pads on opposite surfaces of the package substrate. As such, the length of the interconnects can be reduced and losses are reduced. In addition to angled vias, embodiments disclosed herein also allow for the formation of angled via planes. In an embodiment, the angled vias and angled via planes may be used for the formation of package substrates of test socket architectures.

In an embodiment, angled vias and angled via planes may be formed with a laser-assisted etching process. Generally, laser-assisted etching processes involve exposing the core to a laser. In the case of angled features, the laser is angled at a non-orthogonal angle with respect to the surface of the core. The laser exposure results in a change in the morphology of the exposed regions. For example, in a glass core, the structure may turn from amorphous to crystalline after exposure by the laser. The change in structure allows for selective etching of the exposed regions. After etching, conductive material may be disposed in the openings.

The laser-assisted etching process allows for the formation of crack free, high-density via holes and planes into the core substrate. Whereas existing through core vias (e.g., PTHs) have diameters of 100µm or larger and pitches of 250µm or larger, the laser-assisted etching process may enable hole diameters and plane thicknesses that are approximately 50µm or smaller and pitches that are approximately 40µm or larger. Diameters of the holes and thicknesses of planes may be able to be approximately 10µm without masks, and potentially as small as 2µm when a hardmask is also used. The thickness of the core may also be between approximately 100µm and 1,000µm . Though it is to be appreciated that embodiments may also apply to larger and/or smaller hole diameters, plane thicknesses, pitches, and core substrate thicknesses.

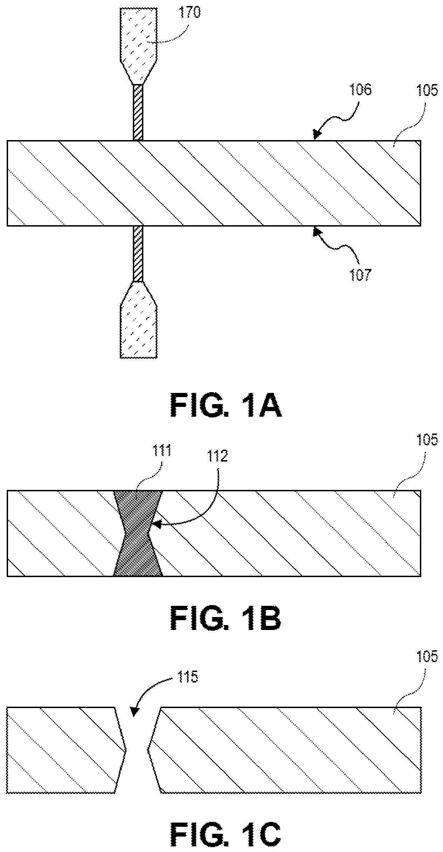

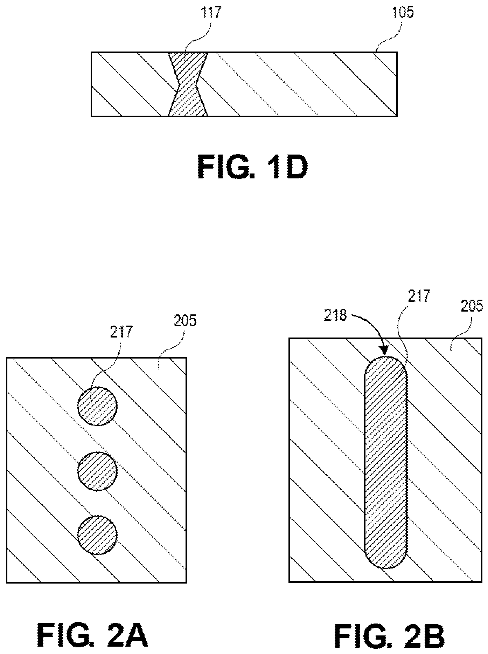

Referring now to Figures 1A-1D, a series of cross-sectional illustrations depicting a process for forming a hole in a core substrate 105 using a laser-assisted etching process is shown, in accordance with an embodiment. In Figures 1A-1D, the hole is shown in a single cross-section. However, it is to be appreciated that the hole may be extended to form trenches suitable for the formation of vertically oriented planes in addition to standard vias. In Figures 1A-1D, vertically oriented features are shown, but it is to be appreciated that angled features may be formed with similar processes by tilting the laser making the exposure.

As shown in Figure 1A, the core substrate 105 is exposed by a laser 170. The laser 170 may be irradiated over both a first surface 106 and a second surface 107. However, the laser 170 may only irradiate a single surface of the core substrate 105 in other embodiments. In order to form a trench for a vertically oriented plane, the laser 170 may be scanned across the surface of the core substrate 105. In Figure 1A, the laser 170 is oriented orthogonally with the first surface 106. However, it is to be appreciated that the laser 170 may be tilted so that the laser exposes the core substrate 105 at a non-orthogonal angle. Such angled exposures enable the formation of angled vias and angled planes, as will be described in greater detail below.

In an embodiment, the core substrate 105 may comprise a material that is capable of forming a morphological change as a result of the exposure by the laser 170. For example, in the case of a glass core substrate 105, the morphological change may result in the conversion of an amorphous crystal structure to a crystalline crystal structure. While glass is used as an example here, it is to be appreciated that the core substrate 105 may also comprise ceramic materials, silicon, or other non-conductive semiconductor materials. In an embodiment, the core substrate 105 may have a thickness between the first surface 106 and the second surface 107 that is between 100µm and 1,000µm. However, it is to be appreciated that larger or smaller thicknesses may also be used for the core substrate 105 in other embodiments.

Referring now to Figure 1B, a cross-sectional illustration of the core substrate 105 after the morphological change has occurred is shown, in accordance with an embodiment. As shown, an exposed region 111 is provided through a thickness of the core substrate 105. In an embodiment, the exposed region 111 may have sidewalls 112 that are sloped. That is, the sidewalls 112 may not be substantially vertical (with respect to the first surface 106 and the second surface 107). In a particular embodiment, the exposed region 111 may have an hourglass shaped cross-section that results from exposure from laser exposure on both the first surface 106 and the second surface 107. As used herein, an hourglass shaped cross section may refer to a shape that starts with a first width on a first end, decreases in width while moving away from the first end until reaching a minimum width between the first end and a second end, and increasing in width while moving from the minimum width in the middle towards the second end. That is, the shape may have a middle region that is narrower in width than the widths of the opposing ends. In an embodiment, the sidewalls 112 may have a slope that is approximately 10° or less away from vertical. While shown with sloped sidewalls 112, it is also to be appreciated that embodiments may include substantially vertical sidewalls depending on the laser parameters and the material of the core substrate 105.

In Figure 1B, the exposed region 111 extends through an entire thickness of the core substrate 105. However, it is to be appreciated that blind features may also be formed with the laser-assisted etching process. As used herein, a blind feature refers to a feature that extends into, but not through, the thickness of a substrate. In the case of a blind feature, the laser parameters are chosen so the morphological change of the exposed region 111 extends partially into, but not through, a thickness of the core substrate 105. It is to be appreciated that control of the laser parameters can provide a depth to the blind feature that is accurate to within a few microns.

Referring now to Figure 1C, a cross-sectional illustration of the core substrate 105 after the exposed region 111 is removed to form a hole 115 through the core substrate 105 is shown, in accordance with an embodiment. Similarly, in the case of forming a vertically oriented plane, a trench may be formed instead of a hole 115. In an embodiment, the hole 115 may be formed with an etching process that is selective to the exposed region 111 over the remainder of the core substrate 105. The etch selectivity of the exposed region 111 to the remainder of the core substrate 105 may be 10:1 or greater, or 50:1 or greater. That is, while selective to the exposed region 111, some portion of the core substrate 105 may also be etched, resulting in the thickness of the core substrate 105 being slightly reduced. In an embodiment, the etchant may be a wet etching chemistry.

Referring now to Figure ID, a cross-sectional illustration of the core substrate 105 after a via 117 is formed in the hole 115 is shown, in accordance with an embodiment. In the case of a hole 115 that is extended into a trench, the via 117 may instead be a vertically oriented plane. In an embodiment, the via 117 may be deposited with a plating process or any other suitable deposition process.

In an embodiment, the hole 115 may have a maximum diameter that is approximately 100µm or less, approximately 50µm or less, or approximately 10µm or less. The pitch between individual holes 115 in the core substrate 105 may be between approximately 10µm and approximately 100µm in some embodiments. The small diameters and pitch (compared to traditional PTH vias that typically have diameters that are 100µm or larger and pitches that are 100µm or larger) allow for high density integration of vias and vertically oriented planes.

In Figures 1A-1D only a single cross-section of the core substrate 105 is shown for simplicity. However, it is to be appreciated that the shape of the vias 117 may take substantially any form. This is because the laser providing the morphological change in the core substrate 105 may be moved in a controllable manner. Examples of various plan views of a vias 217 in a core substrate 205 are shown in Figures 2A and 2B.

Referring now to Figure 2A, a plan view illustration of a core substrate 205 with a plurality of circular vias 217 is shown, in accordance with an embodiment. While three vias 217 are shown, it is to be appreciated that any number of vias 217 may be provided in any configuration. Referring now to Figure 2B, a plan view illustration of a core substrate 205 with a via 217 that is extended along one direction to form a vertically oriented plane is shown, in accordance with an embodiment. Such a structure 217 may be referred to herein as a "via plane" or simply a "plane". The plane 217 may have a thickness through the core substrate 205 that is substantially uniform, while also being extended in a direction, as opposed to having a width and length that are substantially uniform. As shown in Figure 2B, the ends of the plane 217 may be rounded surfaces 218. The rounded surfaces may be the result of the shape of the laser irradiation. That is, the focus of the laser may be substantially circular in some embodiments. In Figure 2B, the plane 217 is shown as a straight line. However, it is to be appreciated that the via plane 217 may also include turns.

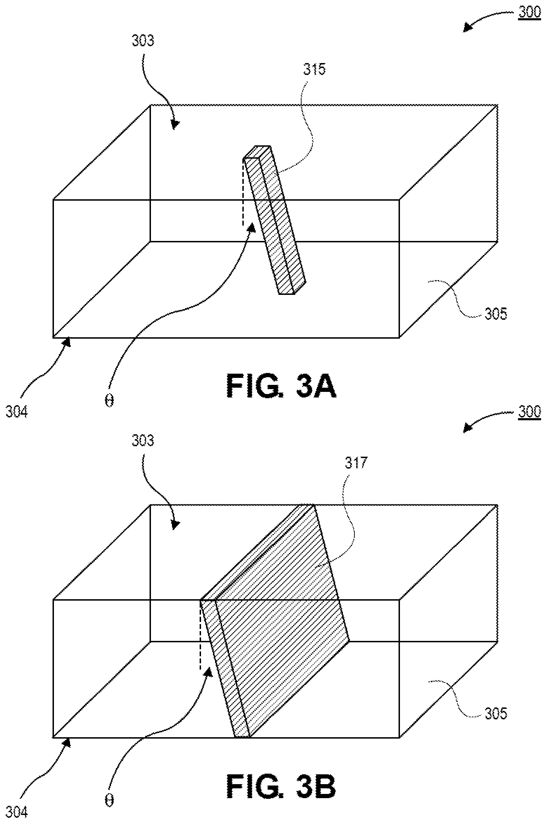

Referring now to Figure 3A, a perspective view illustration of a package substrate 300 is shown, in accordance with an embodiment. In an embodiment, the package substrate 300 comprises a core 305. The core 305 may be a material that can be patterned with a laser-assisted etching process, such as the process described in greater detail above. For example, the core 305 may be a glass core. As shown, a via 315 is provided through a thickness of the core 305 from a first surface 303 to a second surface 304.

In an embodiment, the via 315 may be an angled via 315. That is, sidewalls of the via 315 may be at a non-orthogonal angle with the first surface 303 of the core. As shown, the via 315 may be oriented at an angle θ relative to a plane that is orthogonal to the first surface 303. In an embodiment, the angle θ may be between approximately 0° and approximately 90°. The angle θ is controlled by the angle of the laser exposure in the laser-assisted etching process. In the illustrated embodiment, the angled via 315 has substantially vertical sidewalls. In other embodiments, the angled via 315 may have sidewalls with a taper, an hourglass shaped cross-section, or other similar sidewall profiles characteristic of laser-assisted etching processes. Additionally, while shown as extending from the first surface 303 to the second surface 304, it is to be appreciated that the angled via 315 may also be a blind feature in some embodiments.

Referring now to Figure 3B, a perspective view illustration of a package substrate 300 is shown, in accordance with an additional embodiment. In an embodiment, the package substrate 300 comprises a core 305, such as a glass core. In an embodiment, an angled via plane 317 is provided through a thickness of the core 305 from a first surface 303 to a second surface 304. As shown, the angled via plane 317 may be oriented at an angle θ relative to a plane that is orthogonal to the first surface 303. In an embodiment, the angle θ may be between approximately 0° and approximately 90°. The angle θ is controlled by the angle of the laser exposure in the laser-assisted etching process. In the illustrated embodiment, the angled via plane 317 has substantially vertical sidewalls. In other embodiments, the angled via plane 317 may have sidewalls with a taper, an hourglass shaped cross-section, or other similar sidewall profiles characteristic of laser-assisted etching processes. Additionally, while shown as extending from the first surface 303 to the second surface 304, it is to be appreciated that the angled via plane 317 may also be a blind feature in some embodiments.

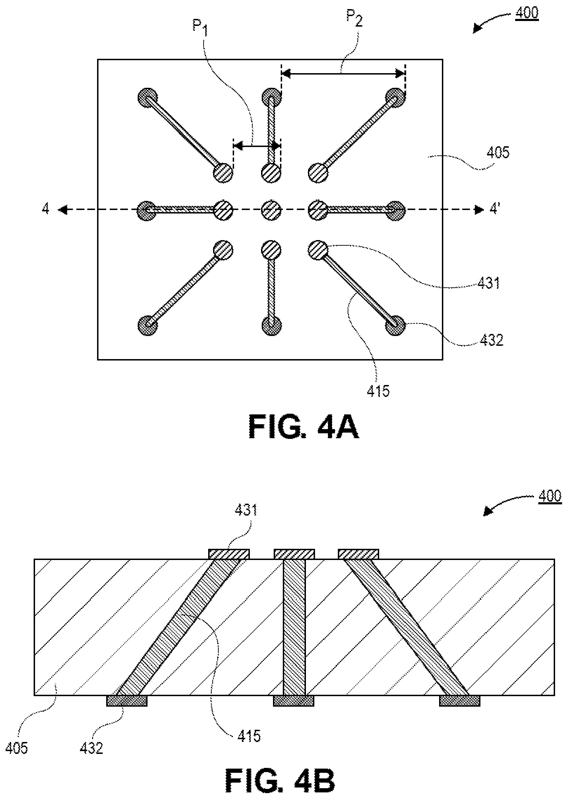

The angled via 315 and the angled via plane 317 in Figures 3A and 3B may be used to provide routing within the package substrate 300. In a particular embodiment, angled vias 317 may be used to provide pitch translation between an array of first pads on the first surface 303 of the core 305 and an array of second pads on the second surface 304. An example of such an embodiment is shown in Figure 4A.

Referring now to Figure 4A, a plan view illustration of an electronic package 400 is shown, in accordance with an embodiment. In an embodiment, the electronic package 400 comprises a core 405, such as a glass core 405. In an embodiment, an array of first pads 431 may be provided on a top surface of the core 405. The first pads 431 may have a first pitch P₁. The first pitch P₁ may be a pitch suitable for first level interconnects (FLIs) that are used to couple the electronic package 400 to a die.

In an embodiment, an array of second pads 432 may be provided on a bottom surface of the core 405. That is, the pads 431 and 432 in Figure 4A are on opposite surfaces of the core 405. The second pads 432 may have a second pitch P₂. The second pitch P₂ may be larger than the first pitch P₁. The second pitch P₂ may be suitable for providing second level interconnects (SLIs) that are used to couple the electronic package 400 to a board or the like. Of course, it is to be appreciated that each surface of the core 405 may have mixed pitches. That is, the first pads 431 may have the first pitch P₁ and additional pitches (e.g., P₃ or P₄), and the second pads 432 may have the second pitch P₂ and additional pitches (e.g., P₅ or P₆).

In an embodiment, angled vias 415 through a thickness of the core 405 connect individual ones of the first pads 431 to corresponding ones of the second pads 432. In an embodiment, the second pads 432 are at least partially outside a footprint of the corresponding first pad 431 to which the second pad 432 is connected. As used herein, "footprint" may refer to the outer perimeter of a feature in the X-Y plane and the space within the outer perimeter of the feature in the X-Y plane. Being "within the footprint" implies that two objects occupy at least some of the same space in X-Y plane, but at different Z-heights. Being "outside the footprint" implies that two objects do not share the same space in the X-Y plane. The angled vias 415 provide a direct point-to-point connection between the first pads 431 and the second pads 432. That is, there is no need for lateral routing to provide the fanning out to a large pitch. As such, pitch translation can be implemented entirely within the core without the need for additional redistribution layers above (or below) the core 405. As such, the interconnects have lower losses.

Referring now to Figures 4B-4D, a series of cross-sectional illustrations depicting several different cross-section embodiments along line 4-4' in Figure 4A is shown, in accordance with various embodiments.

Referring now to Figure 4B, a cross-sectional illustration of the package substrate 400 is shown, in accordance with an embodiment. In an embodiment, the package substrate 400 comprises angled vias 415 that are a straight line between the first pad 431 and the second pad 432. In some embodiments, the angled vias 415 may be formed with a single sided laser exposure.

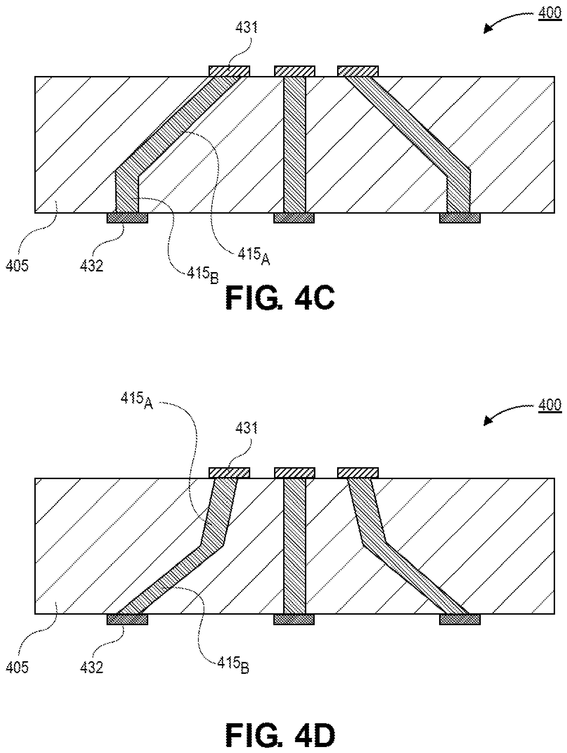

Referring now to Figure 4C, a cross-sectional illustration of the package substrate 400 is shown, in accordance with an additional embodiment. As shown, the angled vias 415 comprise a first portion 415_{A} and a second portion 415_{B}. The first portion 415_{A} may be angled, and the second portion 415_{B} may be substantially vertical. That is, the angled first portion 415_{A} does not need to pass through an entire thickness of the core 405. In the illustrated embodiment, the angled first portion 415_{A} contacts the first pad 431 and the vertical second portion 415_{B} contacts the second pad 432. However, it is to be appreciated that the vertical second portion 415_{B} and the angled first portion 415_{A} may be switched so that the vertical second portion 415_{B} contacts the first pad 431 and the angled first portion 415_{A} contacts the second pad 432. In an embodiment, the angled via 415 may be formed with a dual sided laser exposure. An angled exposure on the top surface of the core 405 may be used to form the angled first portion 415_{A}, and a vertical exposure on the bottom surface of the core 405 may be used to form the vertical second portion 415_{B}. In an embodiment, the angled first portion 415_{A} and the vertical second portion 415_{B} may have similar shapes and/or diameters. In other embodiments, the angled first portion 415_{A} and the vertical second portion 415_{B} may have different shapes and/or diameters.

Referring now to Figure 4D, a cross-sectional illustration of the package substrate 400 is shown, in accordance with yet another additional embodiment. In an embodiment, the package substrate 400 may comprise an angled via 415 with a first portion 415_{A} and a second portion 415_{B}. Both the first portion 415_{A} and the second portion 415_{B} may be angled. However, the angle (relative to the top surface of the core) for the first portion 415_{A} may be different than the angle for the second portion 415_{B}. In an embodiment, a dual sided laser exposure may be used to form the package substrate 400 in Figure 4D. In an embodiment, the first portion 415_{A} and the second portion 415_{B} may have similar shapes and/or diameters. In other embodiments, the first portion 415_{A} and the second portion 415_{B} may have different shapes and/or diameters.

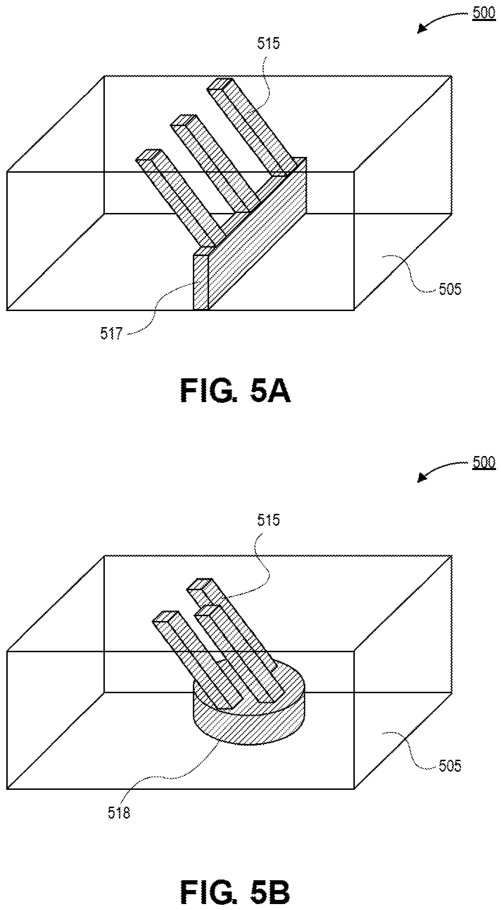

Referring now to Figure 5A, a perspective view illustration of a package substrate 500 is shown, in accordance with an additional embodiment. In an embodiment, the package substrate 500 may comprise a core 505, such as a glass core 505. In an embodiment, a vertical via plane 517 may be provide into the bottom surface of the core 505. The vertical via plane 517 may be a blind structure. That is, the vertical via plane 517 does not extend entirely through a thickness of the core 505.

In an embodiment, a plurality of angled vias 515 may be connected to the vertical via plane 517. In an embodiment, the angled vias 515 may extend from a top surface of the core 505 to the top surface of the via plane 517. The angled vias 515 may also be blind structures. That is, the angled vias 515 do not pass through an entire thickness of the core 505. Such a structure may be used when a plurality of pads (not shown) are tied together, such as a plurality of ground or power signals. In Figure 5A, each of the angled vias 515 are shown with a substantially similar angle with respect to the surface of the core 505. However, it is to be appreciated that in other embodiments, angled vias 515 may have non-uniform angles with respect to the surface of the core 505. While shown as a vertically oriented via plane 517, it is to be appreciated that the via plane 517 may also be angled in some embodiments. Additionally, while the via plane 517 is shown as a linear plane, it is to be appreciated that the via plane 517 may comprise any shape, such as a ring or any other shape the has bends or turns along the length of the via plane 517.

Referring now to Figure 5B, a perspective view illustration of a package substrate 500 is shown in accordance with an additional embodiment. As shown, a plurality of angled vias 515 may each contact the surface of a via 518. The via 518 may have a surface area that is sufficient to accept each of the angled vias 515. In an embodiment, the angled vias 515 may not be arranged linearly (as is shown in Figure 5A). Instead, the angled vias 515 are arranged in a triangular like pattern. However, it is to be appreciated that more or fewer angled vias 515 in any pattern may land on a via 518. Additionally, while the via 518 is shown as being circular, the via 518 can comprise any shape.

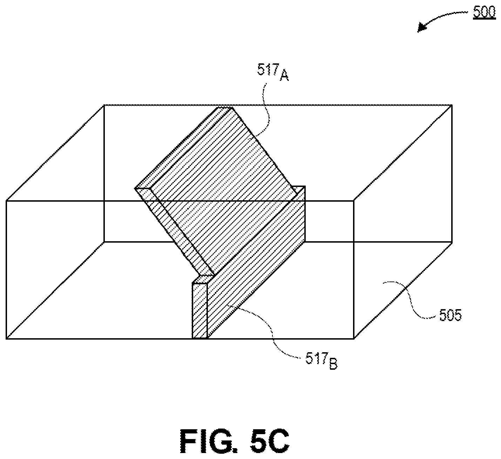

Referring now to Figure 5C, a perspective view illustration of a package substrate 500 is shown, in accordance with an additional embodiment. As shown, an angled via plane 517_{A} intersects a vertically oriented via plane 517_{B}. In the illustrated embodiment, the angled via plane 517_{A} has a width that is different (smaller) than a width of the vertically oriented via plane 517_{B}. But it is to be appreciated that the angled via plane 517_{A} may have a width that is substantially equal to the width of the vertically oriented via plane 517_{B}. While shown as an angled via plan 517_{A} connected to a vertically oriented via plane 517_{B}, it is to be appreciated that two angled via planes 517_{A} may contact each other in other embodiments.

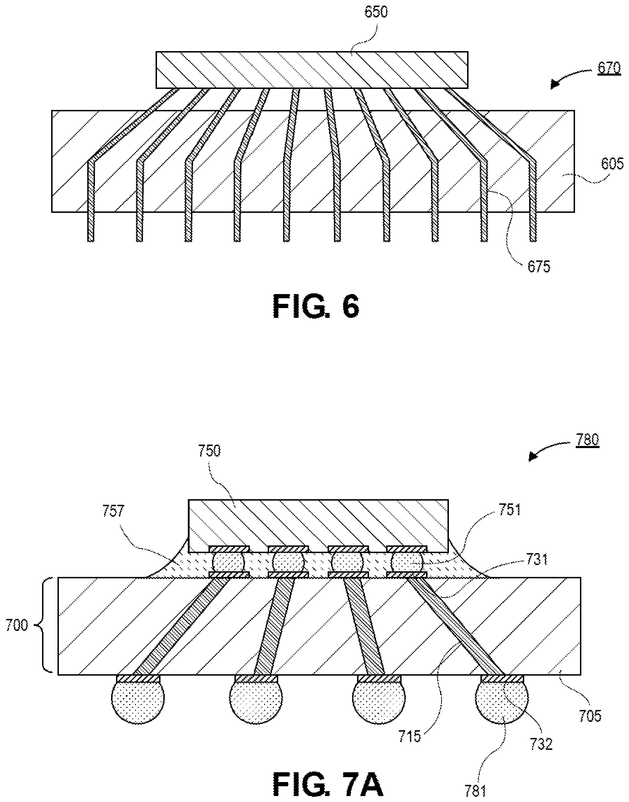

Referring now to Figure 6, a cross-sectional illustration of an die 650 and a test socket 670 is shown, in accordance with an embodiment. Particularly, it is to be appreciated that the ability to form angled vias within a core allows for fabrication of test sockets. As shown in Figure 6, pins 675 may extend through a core 605. The pins 675 may have an angled end that contacts the die 650 and a vertical end that contacts a test board (not shown). In order to fabricate such a device, a laser-assisted etching process may form the pins 675 entirely within the core 605. The surfaces of the core 605 may then be recessed in order to expose the ends of the pins 675 that will contact the die 650 and the board.

Referring now to Figure 7A, a cross-sectional illustration of an electronic package 780 is shown, in accordance with an embodiment. In an embodiment, the electronic package 780 comprises a package substrate 700 and a die 750 coupled to the package substrate 700. In an embodiment, the package substrate 700 comprises a core 705. First pads 731 are on a top surface of the core 705 and second pads 732 are on a bottom surface of the core 705. In an embodiment, angled vias 715 provide pitch translation through the core 705 from the first pads 731 to the second pads 732.

In an embodiment, the second pads 732 may be SLI pads for coupling the package substrate 700 to a board (not shown) with SLIs 781. The first pads 731 may be FLI pads for coupling the package substrate 700 to the die 750 with FLIs 751. In the illustrated embodiment, the first pads 731 and the second pads 732 are shown as protruding from the top and bottom surface of the core 705. However, in other embodiments, the first pads 731 and/or the second pads 732 may be recessed into the core 705. In an embodiment, an underfill 757 surrounds the FLIs 751 over the package substrate 700. Additionally, while shown without any buildup layers, it is to be appreciated that in some embodiments, one or more buildup layers may be provide above and/or below the core 705. In some embodiments employing hybrid bonding processes the FLIs 751 and the underfill 757 are not present.

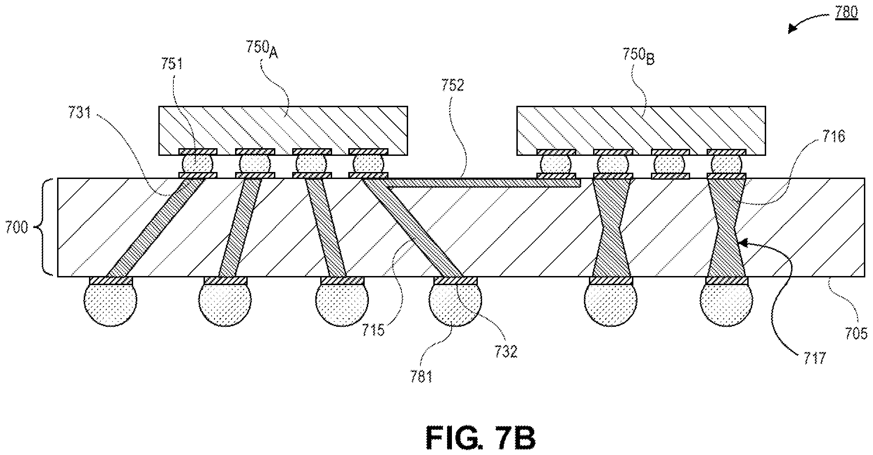

Referring now to Figure 7B, a cross-sectional illustration of an electronic package 780 is shown, in accordance with an additional embodiment. The electronic package 780 in Figure 7B may be similar to the electronic package 780 in Figure 7A, with the exception of there being two dies 750_{A} and 750_{B}. In an embodiment, the second die 750_{B} may be communicatively coupled to the first die 750_{A} by a trace 752 on the core

705. In an embodiment the trace is formed by a laser-assisted etching step and subsequent metal deposition. In an embodiment, angled vias 715 may provide pitch translation below the first die 750_{A}. For the second die 750_{B}, pitch translation may not be necessary in some embodiments. In such a case, vertical vias 716 may connect first pads 731 to second pads 732. As shown in Figure 7B, the vertical via 716 may have sidewalls 717 that produce the characteristic hourglass shaped cross-section of laser-assisted etching processes. While shown as having straight sidewalls, it is to be appreciated that the angled vias 715 may also have tapered sidewalls in some embodiments.

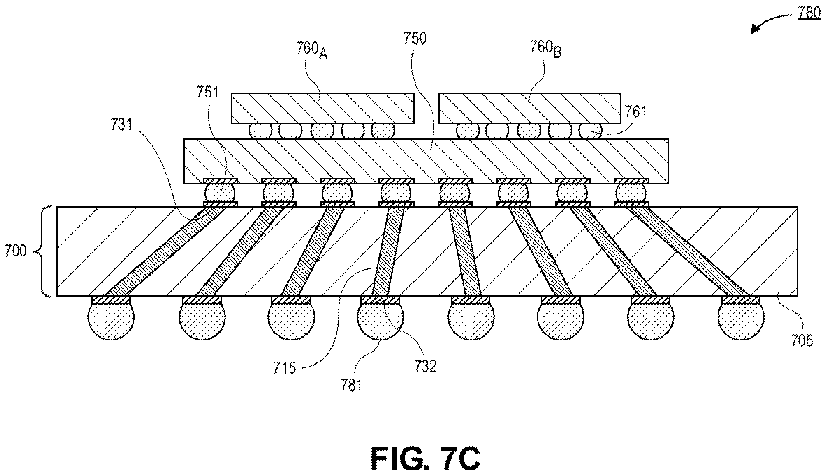

Referring now to Figure 7C, a cross-sectional illustration of an electronic package 780 is shown, in accordance with an additional embodiment. As shown, the package substrate 700 may comprise a core 705 with a plurality of angled vias 715 to connect first pads 731 to second pads 732. In an embodiment, the first pads 731 may be coupled to a base die 750 by FLIs 751. A plurality of chiplets 760_{A} and 760_{B} may be coupled to the base die 750 by interconnects 761. In an embodiment, the base die 750 may be at a first processing node and the chiplets 760 may be at a second, more advanced, processing node. The base die 750 may communicatively couple together the plurality of chiplets 760. In some embodiments employing hybrid bonding processes the interconnects 761 and/or 751 are not present.

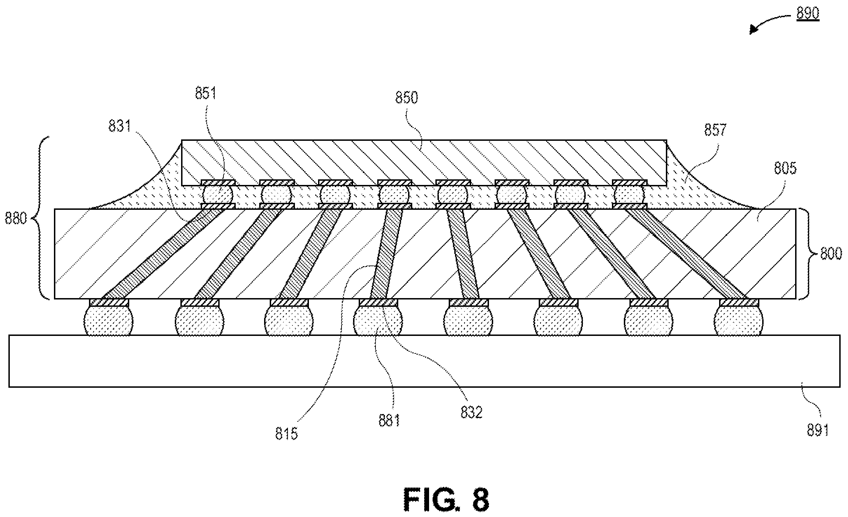

Referring now to Figure 8, a cross-sectional illustration of an electronic system 890 is shown, in accordance with an embodiment. In an embodiment, the electronic system 890 comprises a board 891, such as a printed circuit board (PCB) or the like. The board 891 may be coupled to an electronic package 880 by interconnects 881. The interconnects 881 may be disposed on second pads 832 on the package substrate 800. In an embodiment, first pads 831 on the core 805 may be coupled to the second pads 832 by angled vias 815. The angled vias 815 may be similar to any of the embodiments described in greater detail above. Additionally, angled via planes (not shown) may also be provided in the core 805. In an embodiment, a die 850 may be coupled to the first pads 831 by FLIs 851. An underfill 857 may surround the FLIs 851. In the illustrated embodiment, the package substrate 800 only comprise a core 805. However, in other embodiments one or more buildup layers may be provided above and/or below the core 805. In some embodiments employing hybrid bonding processes the FLIs 851 and the underfill 857 are not present.

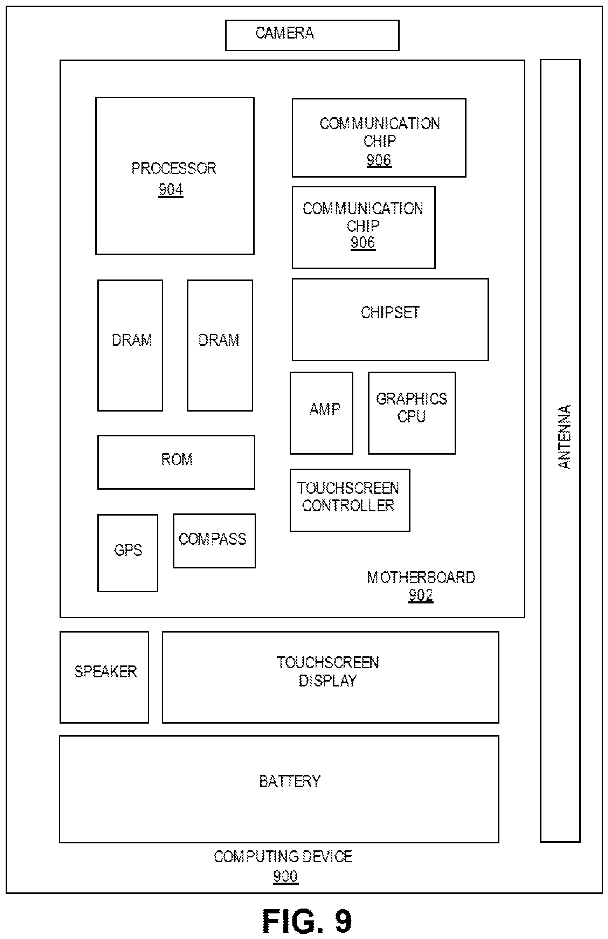

Figure 9 illustrates a computing device 900 in accordance with one implementation of the invention. The computing device 900 houses a board 902. The board 902 may include a number of components, including but not limited to a processor 904 and at least one communication chip 906. The processor 904 is physically and electrically coupled to the board 902. In some implementations the at least one communication chip 906 is also physically and electrically coupled to the board 902. In further implementations, the communication chip 906 is part of the processor 904.

These other components include, but are not limited to, volatile memory (e.g., DRAM), non-volatile memory (e.g., ROM), flash memory, a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth).

The communication chip 906 enables wireless communications for the transfer of data to and from the computing device 900. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 906 may implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing device 900 may include a plurality of communication chips 906. For instance, a first communication chip 906 may be dedicated to shorter range wireless communications such as Wi-Fi and Bluetooth and a second communication chip 906 may be dedicated to longer range wireless communications such as GPS, EDGE, GPRS, CDMA, WiMAX, LTE, Ev-DO, and others.

The processor 904 of the computing device 900 includes an integrated circuit die packaged within the processor 904. In some implementations of the invention, the integrated circuit die of the processor may be part of an electronic package that comprises a package substrate with a core that is patterned with a laser-assisted etching process to form angled vias and/or angled via planes, in accordance with embodiments described herein. The term "processor" may refer to any device or portion of a device that processes electronic data from registers and/or memory to transform that electronic data into other electronic data that may be stored in registers and/or memory.

The communication chip 906 also includes an integrated circuit die packaged within the communication chip 906. In accordance with another implementation of the invention, the integrated circuit die of the communication chip may be part of an electronic package that comprises a package substrate with a core that is patterned with a laser-assisted etching process to form angled vias and/or angled via planes, in accordance with embodiments described herein.

The above description of illustrated implementations of the invention, including what is described in the Abstract, is not intended to be exhaustive or to limit the invention to the precise forms disclosed. While specific implementations of, and examples for, the invention are described herein for illustrative purposes, various equivalent modifications are possible within the scope of the invention, as those skilled in the relevant art will recognize.

These modifications may be made to the invention in light of the above detailed description. The terms used in the following claims should not be construed to limit the invention to the specific implementations disclosed in the specification and the claims. Rather, the scope of the invention is to be determined entirely by the following claims, which are to be construed in accordance with established doctrines of claim interpretation.

Example 1: a package substrate, comprising: a core with a first surface and a second surface opposite from the first surface; a first pad on the first surface; a second pad on the second surface, wherein the second pad is outside a footprint of the first pad; and a via through a thickness of the core, wherein the via connects the first pad to the second pad.

Example 2: the package substrate of Example 1, wherein the via is an angled via with a non-orthogonal angle relative to the first surface of the core.

Example 3: the package substrate of Example 1 or Example 2, wherein the via comprises a first portion and a second portion, wherein the first portion is angled with a non-orthogonal angle relative to the first surface of the core.

Example 4: the package substrate of Example 3, wherein the first portion contacts the first pad, and wherein the second portion contacts the second pad.

Example 5: the package substrate of Example 3, wherein the second portion contacts the first pad, and wherein the first portion contacts the second pad.

Example 6: the package substrate of Example 3, wherein the second portion is angled with a non-orthogonal angle relative to the first surface of the core.

Example 7: the package substrate of Examples 1-6, wherein the via is a via plane.

Example 8: the package substrate of Examples 1-7, wherein the first pad and the second pad are recessed into the core.

Example 9: the package substrate of Examples 1-8, wherein the core is a glass core.

Example 10: an electronic package, comprising: a core with a first surface and a second surface opposite from the first surface; an array of first pads on the first surface, wherein the array of first pads have a first pitch; and an array of second pads on the second surface, wherein the array of second pads have a second pitch that is greater than the first pitch; and a plurality of vias through the core, wherein individual ones of the first pads are coupled to a corresponding one of the second pads by an individual one of the plurality of vias.

Example 11: the electronic package of Example 10, wherein individual ones of the plurality of vias have a first portion contacting an individual one of the first pads, and a second portion contacting an individual one of the second pads.

Example 12: the electronic package of Example 11, wherein the first portion is angled at a non-orthogonal angle with respect to the first surface, and wherein the second portion is orthogonal to the first surface.

Example 13: the electronic package of Example 11, wherein the first portion is orthogonal to the first surface, and wherein the second portion is angled at a non-orthogonal angle with respect to the first surface.

Example 14: the electronic package of Example 11, wherein the first portion is angled at a non-orthogonal angle with respect to the first surface, and wherein the second portion is angled at a non-orthogonal angle with respect to the first surface.

Example 15: the electronic package of Example 11, wherein the first portion has a first diameter and a first shape, and wherein the second portion has a second diameter and a second shape, and wherein the first diameter is different than the second diameter, and/or wherein the first shape is different than the second shape.

Example 16: the electronic package of Examples 10-15, further comprising: a via plane embedded in the core, wherein one or more of the vias contact a the via plane.

Example 17: the electronic package of Examples 10-16, further comprising: a first via plane embedded in the core, wherein the first via plane is angled at a non-orthogonal angle with respect to the first surface; and a second via plane embedded in the core, wherein the second via plane contacts the first via plane.

Example 18: the electronic package of Example 17, wherein a width of the first via plane is different than a width of the second via plane.

Example 19: the electronic package of Example 17 or Example 18, wherein the second via plane is orthogonal to the first surface.

Example 20: the electronic package of Examples 10-19, wherein the core is a glass core.

Example 21: an electronic system, comprising: a board; a package substrate coupled to the board, wherein the package substrate comprises: a core with a first surface and a second surface opposite from the first surface; an array of first pads on the first surface, wherein the array of first pads have a first pitch; and an array of second pads on the second surface, wherein the array of second pads have a second pitch that is greater than the first pitch; and a plurality of vias through the core, wherein individual ones of the first pads are coupled to a corresponding one of the second pads by an individual one of the plurality of vias; and a die coupled to the package substrate.

Example 22: the electronic system of Example 21, wherein the board is coupled to the package substrate by second level interconnects at the second pitch, and wherein the die is coupled to the package substrate by first level interconnects at the first pitch.

Example 23: the electronic system of Example 22, wherein individual ones of the plurality of vias have a first portion contacting an individual one of the first pads, and a second portion contacting an individual one of the second pads.

Example 24: the electronic package of Example 23, wherein the first portion is angled at a non-orthogonal angle with respect to the first surface, and wherein the second portion is orthogonal to the first surface.

Example 25: the electronic package of Example 23, wherein the first portion is orthogonal to the first surface, and wherein the second portion is angled at a non-orthogonal angle with respect to the first surface.

## Claims

1. A package substrate, comprising:
a core with a first surface and a second surface opposite from the first surface;
a first pad on the first surface;
a second pad on the second surface, wherein the second pad is outside a footprint of the first pad; and
a via through a thickness of the core, wherein the via connects the first pad to the second pad.

2. The package substrate of claim 1, wherein the via is an angled via with a non-orthogonal angle relative to the first surface of the core.

3. The package substrate of claim 1 or 2, wherein the via comprises a first portion and a second portion, wherein the first portion is angled with a non-orthogonal angle relative to the first surface of the core.

4. The package substrate of claim 3, wherein the first portion contacts the first pad, and wherein the second portion contacts the second pad.

5. The package substrate of claim 3, wherein the second portion contacts the first pad, and wherein the first portion contacts the second pad.

6. The package substrate of claim 3, wherein the second portion is angled with a non-orthogonal angle relative to the first surface of the core.

7. The package substrate of claim 1, 2, 3, 4, 5 or 6, wherein the via is a via plane.

8. The package substrate of claim 1, 2, 3, 4, 5, 6 or 7, wherein the first pad and the second pad are recessed into the core.

9. The package substrate of claim 1, 2, 3, 4, 5, 6, 7 or 8, wherein the core is a glass core.

10. A method of fabricating a package substrate, the method comprising:
providing a core with a first surface and a second surface opposite from the first surface;
forming a first pad on the first surface;
forming a second pad on the second surface, wherein the second pad is outside a footprint of the first pad; and
forming a via through a thickness of the core, wherein the via connects the first pad to the second pad.

11. The method of claim 10, wherein the via is an angled via with a non-orthogonal angle relative to the first surface of the core.

12. The method of claim 10 or 11, wherein the via comprises a first portion and a second portion, wherein the first portion is angled with a non-orthogonal angle relative to the first surface of the core.

13. The method of claim 12, wherein the first portion contacts the first pad, and wherein the second portion contacts the second pad.

14. The method of claim 12, wherein the second portion contacts the first pad, and wherein the first portion contacts the second pad.

15. The method of claim 12, wherein the second portion is angled with a non-orthogonal angle relative to the first surface of the core.
